(19) Europäisches Patentamt
European Patent Office
Office européen des brevets

(11) **EP 2 743 717 B1**

(12) **FASCICULE DE BREVET EUROPEEN**

(45) Date de publication et mention
de la délivrance du brevet:
**13.09.2017 Bulletin 2017/37**

(51) Int Cl.:
*G01R 33/38* (2006.01)     *G01R 33/381* (2006.01)
*G01R 33/3875* (2006.01)    *G01R 33/44* (2006.01)
*H01F 7/20* (2006.01)

(21) Numéro de dépôt: **13195911.6**

(22) Date de dépôt: **05.12.2013**

(54) **Dispositif de génération d'un champ magnétique orientable et localement homogène**

Vorrichtung zur Erzeugung eines orientierbaren und örtlich homogenen Magnetfelds

Device for generating an orientable locally homogeneous magnetic field

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **14.12.2012 FR 1262070**

(43) Date de publication de la demande:
**18.06.2014 Bulletin 2014/25**

(73) Titulaire: **COMMISSARIAT À L'ÉNERGIE
ATOMIQUE ET AUX
ÉNERGIES ALTERNATIVES
75015 Paris (FR)**

(72) Inventeur: **Aubert, Guy
86000 POITIERS (FR)**

(74) Mandataire: **Gevers & Orès
41 avenue de Friedland
75008 Paris (FR)**

(56) Documents cités:
**WO-A2-2005/029110      WO-A2-2007/048983
US-A1- 2002 031 201     US-A1- 2008 024 130**

- JOZEF CERNÁK ET AL: "Aggregation of
magnetic holes in a rotating magnetic field",
PHYSICAL REVIEW E, vol. 78, no. 6, 1 décembre
2008 (2008-12-01), XP055084417, ISSN:
1539-3755, DOI: 10.1103/PhysRevE.78.061401
- IOFFE A ET AL: "Larmor labelling by thin spin
flippers with rotating magnetic field: simulations
of performance of neutron scattering
instruments", NUCLEAR INSTRUMENTS &
METHODS IN PHYSICS RESEARCH. SECTION A:
ACCELERATORS, SPECTROMETERS,
DETECTORS, AND ASSOCIATED EQUIPMENT,
ELSEVIER BV * NORTH-HOLLAND,
NETHERLANDS, vol. 529, no. 1-3, 21 août 2004
(2004-08-21), pages 45-49, XP004527253, ISSN:
0168-9002, DOI: 10.1016/J.NIMA.2004.04.174

# EP 2 743 717 B1

**Description**

L'invention porte sur un dispositif de génération d'un champ magnétique localement homogène - c'est-à-dire sensiblement homogène dans une région prédéfinie de l'espace - et orientable en trois dimensions, ou au moins dans un plan. L'invention porte également sur l'utilisation d'un tel dispositif.

Certaines expériences scientifiques, notamment de diffraction ou diffusion de neutrons, nécessitent de soumettre un échantillon à un champ magnétique orientable dans toutes les directions de l'espace. Le porte-échantillon est une enceinte cryogénique qui implique que la source de champ comporte un accès libre suivant un cylindre circulaire d'axe vertical. Un espace libre doit également être ménagé de part et d'autre du plan horizontal traversant l'échantillon pour permettre le passage des faisceaux de neutrons suivant une certaine ouverture angulaire. Enfin, le système générateur de champ doit être fixe, l'orientation variable du champ étant obtenue par un ajustement des courants d'alimentation.

Typiquement, on souhaite générer un champ magnétique orientable ayant une amplitude de l'ordre de 1T et une homogénéité meilleure que 5%, voire que 1% dans une sphère de 10 mm de diamètre, laissant un accès axial d'au moins 100 mm de diamètre et une ouverture angulaire équatoriale de l'ordre de 2,5°.

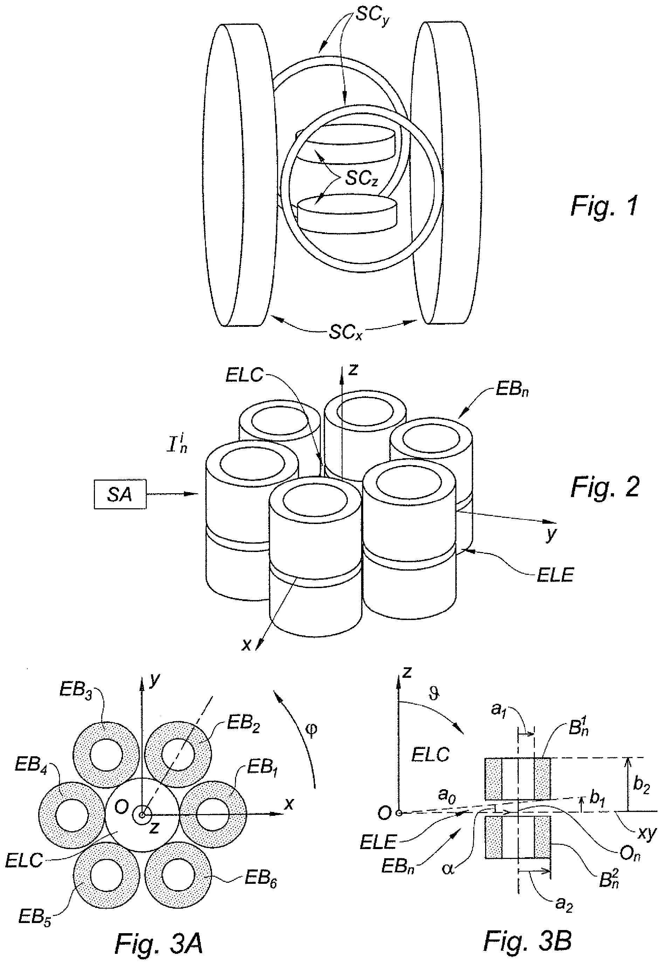

Un champ magnétique orientable présentant les caractéristiques d'amplitude et homogénéité requises peut être généré au moyen du dispositif de la figure 1, comportant trois paires de bobines coaxiales (ou « split coils ») $SC_X$, $SC_Y$, $SC_Z$ dont les axes sont orthogonaux et se croisent au centre de l'échantillon. Un tel dispositif a été installé à la source de neutrons et muons « ISIS » (Royaume Uni) et permet d'obtenir une homogénéité du champ magnétique meilleure que 0,5% sur une sphère de 10mm de diamètre, mais son ouverture angulaire est très limitée. En particulier, il n'y a pas d'ouverture équatoriale continue, mais seulement des accès relativement étroits en correspondance des axes x, y et z.

Un problème lié est celui de la génération d'un champ magnétique tournant (dans un plan ou sur un cône, c'est-à-dire présentant une composante radiale tournante et une composante axiale constante), ce qui est important notamment pour la résonance magnétique nucléaire. Des exigences d'accessibilité sont également présentes dans ces applications. Conformément à l'art antérieur (voir par exemple le document US 2008/0024130) cela est obtenu en faisant tourner un aimant, ce qui pose des problèmes de complexité, de fiabilité et de vibrations.

L'invention vise à surmonter les inconvénients précités de l'art antérieur en procurant un dispositif de génération d'un champ magnétique orientable et/ou tournant et localement homogène présentant à la fois un accès axial pour l'introduction aisée d'un échantillon et une ouverture angulaire équatoriale pour permettre, par exemple, le passage de faisceaux de particules (notamment neutrons) ou rayonnements. Le dispositif de l'invention a été développé pour répondre aux besoins des études de diffraction et diffusion de neutrons, mais peut convenir également à d'autres applications telles que la diffusion de rayons X, la résonance magnétique nucléaire, la magnétométrie statique (en particulier SQUID/VSM et par effet Kerr magnéto-optique) et le magnétotransport.

Certains modes de réalisation permettent en outre d'obtenir un champ magnétique plus homogène que les solutions de l'art antérieur et une valeur maximale du champ magnétique moins élevée, et comprennent un blindage actif.

Un objet de l'invention est donc un dispositif de génération d'un champ magnétique orientable et localement homogène, tel que défini par la revendication 1. Des modes de réalisation avantageux de l'invention sont définis par les revendications 2 à 15. D'autres caractéristiques, détails et avantages de l'invention ressortiront à la lecture de la description faite en référence aux dessins annexés donnés à titre d'exemple et qui représentent, respectivement :

- la figure 2, un dispositif selon le premier mode de réalisation de l'invention, comportant 6 ensembles de bobines ;
- les figures 3A et 3B, deux vues en coupe du dispositif de la figure 2 ;
- les figures 4A et 4B, deux vues en coupe d'un dispositif selon ledit premier mode de réalisation de l'invention, comportant seulement 4 ensembles de bobines ;
- les figures 5A et 5B, deux vues en coupe d'un dispositif selon la première variante du deuxième mode de réalisation de l'invention, comportant 4 ensembles de bobines ;
- les figures 6A et 6B, deux vues en coupe d'un dispositif selon la deuxième variante du deuxième mode de réalisation de l'invention, comportant 4 ensembles de bobines ;
- les figures 7, 8 et 9A/9B, trois dispositifs selon le troisième mode de réalisation de l'invention.

Une idée à la base de l'invention consiste à utiliser une pluralité de bobines coaxiales, régulièrement agencées le long d'un cercle, pour générer un champ magnétique homogène orienté dans une direction radiale (perpendiculaire à la direction axiale), et éventuellement aussi un champ magnétique axial dont l'amplitude peut être fixée indépendamment de celle du champ magnétique radial. Du point de vue structurel, un dispositif selon l'invention présente une ressemblance avec des ensembles de bobines utilisés pour la génération de gradients de champ magnétique axial dans des appareils d'imagerie par résonance magnétique nucléaire, divulgués en particulier par les documents WO2005/029110 et WO2007/048983. On remarquera que dans ces documents il s'agit de générer un champ magnétique axial et inhomogène (car présentant des gradients), alors que la présente invention vise au contraire à générer un champ magnétique radial (ou présentant une composante radiale) et homogène. Un dispositif selon l'invention se différencie donc d'un ensemble de bobines de gradient connu de l'art antérieur par le nombre de bobines qu'il comprend, leur dimensionnement, la présence de bobines additionnelles (dans certaines modes de réalisation) ainsi que par la structure et le fonctionnement du système d'alimentation en courant desdites bobines.

Les figures 2 et 3A/3B illustrent un premier mode de réalisation d'un dispositif selon l'invention. Ce dispositif est constitué par une pluralité (ici, six) d'éléments EB (EB$_1$ - EB$_6$) de forme généralement cylindrique (typiquement, mais pas nécessairement, à base circulaire) présentant des axes parallèles entre eux, selon une direction que l'on désignera par z. Ces éléments sont régulièrement répartis le long d'un cercle de rayon a$_0$ situé dans un plan, que l'on désignera par plan xy, perpendiculaire à ladite direction z. L'on désigne par O le centre du cercle, qui est choisi comme origine du système d'axes Oxyz ; l'axe x est choisi, de manière arbitraire, de façon à passer par le centre de l'un des éléments EB (EB$_1$). La coordonnée azimutale $\varphi_n$ de l'élément EB$_n$ est donc donnée par :

$$\varphi_n = (n-1)\frac{2\pi}{N}, \; n = 1,\dots,N$$

Où N est le nombre d'éléments.

Chaque élément est constitué par un ensemble de bobines, comprenant deux bobines coaxiales ayant des axes orientés le long de la direction z, agencées de manière symétrique par rapport au plan xy. On désignera par B$_n^1$ la bobine de l'élément EB$_n$ qui se trouve du côté des valeurs positives de z et par B$_n^2$ celle qui se trouve du côté des valeurs négatives de z.

On suppose dans un souci de simplicité que toutes ces bobines sont identiques et caractérisées par un rayon interne a$_1$, un rayon externe a$_2$, des extrémités situées à des distances b$_1$ et b$_2$ (avec 0< b$_1$ < b$_2$) du plan xy, et donc une hauteur (b$_2$-b$_1$). On suppose en outre que les bobines présentent des enroulements de densité homogène, et par conséquent une densité azimutale de courant j constante, dont la valeur dépend du courant parcourant la bobine. Ces conditions peuvent être relâchées, mais au prix d'une augmentation de la complexité des calculs nécessaires au dimensionnement du dispositif.

Pour N donné, a$_0$ et a$_2$ sont choisis de telle façon que les bobines soient suffisamment séparées en tenant compte de leurs éléments de structure (mandrins, supports...) et que l'espace libre cylindrique central ELC corresponde aux spécifications. L'espace libre équatorial ELE, de largeur 2b$_1$, est choisi conformément aux spécifications d'ouverture angulaire équatoriale $\alpha$, en tenant compte aussi de la valeur de a$_2$. En effet, comme on peut le voir sur la figure 3B, $\alpha$=tan$^{-1}$[b$_1$/(a$_0$+a$_2$)].

Deux spécifications ont une importance particulière pour définir la géométrie du système, le rayon $\rho_0$ de l'ouverture axiale libre ELC et l'espacement minimal 2d$_0$ entre les surfaces extérieures de deux bobines voisines, dicté par l'encombrement des mandrins et supports. Les deux conditions suivantes doivent donc être respectées :

$$a_0 \geq a_2 + \rho_0$$

$$a_0 \geq \frac{a_2 + d_0}{sin\frac{\pi}{N}}$$

Dans le cas extrême où l'égalité s'applique dans les deux relations ci-dessus, et donc les projections des bobines sur le plan xy sont des cercles tangents au cercle de centre O et de rayon $\rho_0$, espacés entre eux d'une distance 2d$_0$, les valeurs de a$_0$ (qu'on appellera a$_{00}$) et de a$_2$ (qu'on appellera a$_{20}$) sont données par :

$$a_{00} = \frac{\rho_0 - d_0}{1 - sin\frac{\pi}{N}}$$

$$a_{20} = \frac{\rho_0 \sin\dfrac{\pi}{N} - d_0}{1 - \sin\dfrac{\pi}{N}}$$

Si, par exemple, on fixe $\rho_0$=60mm (déterminé en fonction de l'application envisagée) et $2d_0$=6mm (contrainte technologique), on trouve, pour les cas N=4 et N=6 :

$$\begin{bmatrix} \rho = 60\text{mm}_0 \\ 2d_0 = 6 \text{ mm} \end{bmatrix} \rightarrow \begin{bmatrix} N & a_{00} & a_{20} \\ 4 & 194{,}61 \text{ mm} & 134{,}61 \text{ mm} \\ 6 & 114 \text{ mm} & 54 \text{ mm} \end{bmatrix}$$

Dans le cas N=4 on peut choisir $a_0$=146 mm < $a_{00}$. La valeur de $a_2$ est alors contrainte par la première des inégalités ci-dessus : $a_2 \leq a_0 - \rho_0$=86 mm. Cette valeur est inférieur à $a_{20}$=134,61 mm, ce qui signifie que la deuxième inégalité est « inactive » car l'espacement entre les bobines est supérieur à $2d_0$. Dans le cas N=6, au contraire, c'est la deuxième inégalité qui fixe une borne supérieure à la valeur de $a_2$, tandis que la première inégalité est « inactive ».

La hauteur ($b_2$-$b_1$), le diamètre intérieur $a_1$ et la densité de courant j des bobines sont déterminés de façon à obtenir un champ magnétique présentant l'amplitude et l'orientation requises au point O, et qui soit sensiblement homogène (inhomogénéité inférieure ou égale à 5%, de préférence inférieure ou égale à 1 % et de manière encore préférée inférieure à 10 ppm, c'est-à-dire 10 parts par millions) dans une sphère centrée en O et présentant un rayon prédéterminé, par exemple 10 mm.

Pour les calculs de champ, il suffit de connaître les expressions de la composante axiale $B_{zn}$ et de la composante radiale $B_{\rho n}$ du champ d'un aimant à densité de courant azimutale uniforme $j_n$ et à demi-section axiale rectangulaire ($a_1$, $a_2$, $b_1$, $b_2$) dans son référentiel propre et de les sommer vectoriellement. Des formules analytiques et des codes informatiques connus permettent d'effectuer ces calculs rapidement et avec une précision garantie meilleure d'une partie par milliard (ppb).

On démontre que, pour générer magnétique un champ orienté selon la direction z il faut que toutes les densités de courants (et donc toutes les intensités de courant, dans l'hypothèse de bobines identiques) soient identiques et que :

$$B_{zn}\left(j_n, \rho_n = a_0, z_n = 0\right) = \frac{B_0}{2N} \tag{1}$$

où $B_0$ est l'amplitude nominale du champ généré et $\rho_n$, $z_n$ sont, respectivement, la coordonnée radiale et axiale d'un point dans le référentiel propre du n-ème ensemble, dont le centre On est donné par l'intersection de l'axe des bobines qui le constituent et du plan xy. Les coordonnées $\rho_n$=$a_0$, $z_n$=0 correspondent au point O, centre du dispositif.

Pour générer un champ magnétique dans le plan xy orienté selon la direction d'azimut $\varphi_0$ il faut que N soit au moins égal à 3 et les densités de courant doivent être données par :

$$j_n = \pm j_0 \cos\left(\varphi_n - \varphi_0\right) \tag{2}$$

le signe « + » s'appliquant aux bobines situées du côté des valeurs positives de z et le signe «-» à celles situées du côté des valeurs négatives. On a alors :

$$B_0 = N B_{\rho n}\left(j_0, \rho_n = a_0, z_n = 0\right) \tag{3}$$

Pour qu'il soit possible de générer un champ magnétique présentant une direction arbitraire dans l'espace, il faut choisir $a_1$, $b_1$ et $b_2$ de telle sorte que la condition suivante soit satisfaite :

$$B_{\rho n}\left(j_0, \rho_n = a_0, z_n = 0\right) = 2 B_{zn}\left(j_0, \rho_n = a_0, z_n = 0\right) \tag{4}$$

où $\rho_n$ et $z_n$ ont été définis ci-dessus et la composante $B_{\rho n}$ est calculée pour une bobine avec $z_n>0$, ce qui est toujours possible car $B_{zn}$ et $B_{\rho n}$ varient de manière inverse en fonction de $b_2$. On impose également que $a_1>a_{min}$, valeur dictée par des contraintes technologiques, et que le champ généré présente la propriété requises d'homogénéité. Comme cela sera expliqué plus loin, les autres paramètres géométriques peuvent être déterminés, de manière avantageuse mais pas exclusive, par un calcul semi-analytique basé sur un développement du champ magnétique en harmoniques sphériques, de façon à maximiser l'homogénéité dudit champ, ou bien à optimiser une autre fonction objectif tout en assurant une homogénéité satisfaisante du champ magnétique.

On trouve à partir de l'équation (2) que pour générer un champ magnétique d'amplitude $B_0$, angle zénithal (par rapport à l'axe z) $\vartheta_0$ et angle azimutal $\varphi_0$, les deux bobines de l'élément $EB_n$ doivent être alimentées par un courant :

$$I_n^i = I_0 \cdot \left[-cos\vartheta_0 + (-1)^{i-1} sin\vartheta_0 cos(\varphi_n - \varphi_0)\right] \tag{5}$$

où i=1 pour les bobines situées du côté positif de l'axe z et i=2 pour les bobines situées du côté négatif dudit axe. Cela implique que chaque bobine présente une alimentation indépendante. Sur la figure 2 est représenté schématiquement un système d'alimentation SA comprenant 2N=12 générateurs de courant pilotés par un ordinateur programme de manière opportune. L'utilisateur introduit, au moyen d'une interface graphique, les valeurs souhaitées des angles $\vartheta_0$ et $\varphi_0$ et de l'amplitude $B_0$, puis l'ordinateur calcule les 12 intensités de courant $I_n^i$ appliquant l'équation (5) et pilote les générateurs de courant en conséquence.

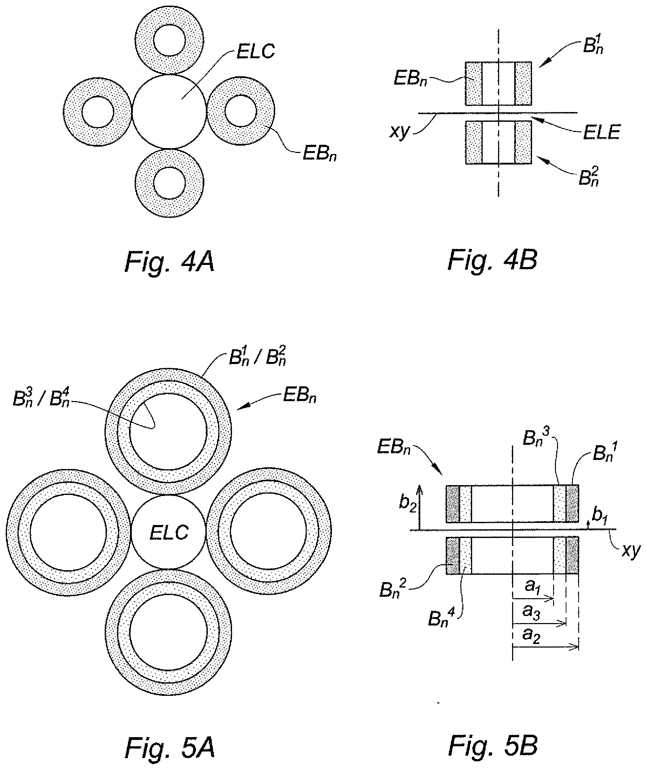

On considérera maintenant deux configurations données à titre d'exemple, la première pour N=6 (figures 2 et 3A/3B) et la deuxième pour N=4 (figures 4A et 4B). Dans le deux cas, il s'agit de générer un champ magnétique d'amplitude $B_0$=1T et les bobines, supraconductrices, peuvent supporter une densité de courant maximale $j_0$=300 A/cm$^2$.

Configuration n°1

Les paramètres fixés a priori sont :

N=6 ;
$a_0$=150 mm
$a_2$=70 mm
$b_1$=15 mm

L'équation (4) permet de calculer (numériquement) : $a_1$=50,6925 mm et $b_1$=113,3675 mm. Pour s'assurer une certaine marge de champ magnétique (c'est-à-dire pour générer un champ magnétique d'amplitude légèrement supérieure à celle requise avec j=$j_0$) on choisit $a_1$=50 mm ; l'équation (4) impose alors de prendre $b_1$=113,5mm. On a donc :

$a_1$=50 mm
$b_1$=113,5mm.

L'amplitude maximale du champ magnétique produit vaut $B_0$=1,02462 T et le volume totale de bobinage vaut 8,912 dm$^3$. Il faut 2N=12 alimentations indépendantes.

Pour N=4 on trouve (après ajustement des valeurs de $a_1$ et $b_1$, comme cela a été fait pour le premier exemple) :

N=4 ;
$a_0$=205 mm
$a_2$=135 mm
$b_1$=25 mm
$a_1$=120 mm
$b_1$=112,2343 mm.

Le volume total de bobinage vaut 8,386 dm$^3$. Il faut 2N=8 alimentations indépendantes.

Afin d'évaluer ces deux configurations, on comparera les homogénéités des champs magnétiques obtenus dans les deux situations extrêmes, soit un champ parallèle à Oz ou un champ parallèle à Ox. La composante principale du champ est évaluée en un certain nombre de points d'une sphère de référence de rayon $r_0$=10 mm et les coefficients de son développement en harmoniques sphériques (DHS) sont calculés par ordinateur.

Ces développements s'écrivent :

$$B_z = B_0 \left\{ 1 + \sum_{n=1}^{\infty} \left(\frac{r}{r_0}\right)^n \left[ Zz_n P_n(cos\vartheta) \right. \right.$$

$$\left. \left. + \sum_{n=1}^{\infty} (Xz_n \cos m\varphi + Yz_n \sin m\varphi) W_n^m P_n^m(cos\vartheta) \right] \right\}$$

$$(6)$$

pour la composante $B_z$, avec

$$W_n^m = \frac{(n-m-1)!!}{(n+m-1)!!}$$

et

$$B_x = Zx_0 + \sum_{n=1}^{\infty} r^n \left[ Zx_n P_n(\cos\vartheta) + \sum_{m=1}^{n} \left( Xx_n^m \cos m\varphi + Yx_n^m \sin m\varphi \right) P_n^m(\cos\vartheta) \right]$$

$$(7)$$

pour la composante $B_x$.

$P_n$ et $P_n^m$ sont, respectivement, les polynômes de Legendre de degré n et les fonctions de Legendre associées de degré n et d'ordre m, tandis que $Zz_n$, $Xz_n^m$, $Yz_n^m$, $Zx_n$, $Xx_n^m$, $Yx_n^m$ sont les coefficients à déterminer.

Pour la première configuration (N=6) les coefficients $Zz_n$, $Xz_n^m$, $Yz_n^m$ du DHS de $B_z$ sont donnés dans le tableau suivant :

| | | | | | | | | | | |
|---|---|---|---|---|---|---|---|---|---|---|
| 0: | 1.024619 | | | | | | | | | |
| 1: | 0.000 | 1: | 0.000 | | | | | | | |
| | | 1: | 0.000 | | | | | | | |
| 2: | 6153.142 | 1: | 0.000 | 2: | 0.000 | | | | | |
| | | 1: | 0.000 | 2: | 0.000 | | | | | |
| 3: | 0.000 | 1: | 0.000 | 2: | 0.000 | 3: | 0.000 | | | |
| | | 1: | 0.000 | 2: | 0-000 | 3: | 0.000 | | | |
| 4: | -202.190 | 1: | 0.000 | 2: | 0.000 | 3: | 0.000 | 4: | 0.000 |
| | | 1: | 0.000 | 2: | 0.000 | 3: | 0.000 | 4: | 0.000 |
| 5: | 0.000 | 1: | 0.000 | 2: | 0.000 | 3: | 0.000 | 4: | 0.000 |
| | | 1: | 0.000 | 2: | 0.000 | 3: | 0.000 | 4: | 0.000 |
| 6: | 2.202 | 1: | 0.000 | 2: | 0.000 | 3: | 0.000 | 4: | 0.000 |
| | | 1: | 0.000 | 2: | 0.000 | 3: | 0.000 | 4: | 0.000 |
| 7: | -0.001 | 1: | 0.000 | 2: | 0.004 | 3: | 0.000 | 4: | 0.000 |

(suite)

| | | 1: | 0.000 | 2: | 0.000 | 3: | 0.000 | 4: | 0.000 |
|---|---|---|---|---|---|---|---|---|---|
| 8: | -0.023 | 1: | 0.000 | 2: | 0.000 | 3: | 0.000 | 4: | 0.000 |
| | | 1: | 0.000 | 2: | 0.000 | 3: | 0.000 | 4: | 0.000 |

où la première colonne indique le degré n suivi de $Z_n$ en ppm, suivi sur la même ligne des ordres m et $X_n^m$ la ligne immédiatement au-dessous donnant les m et $Y_n^m$ en ppm.

Les coefficients $Zx_n$, $Xx_n^m$, $Yx_n^m$ du DHS de $B_x$ sont donnés dans le tableau suivant:

| 0: | 1.024622 | | | | | | | | |
|---|---|---|---|---|---|---|---|---|---|
| 1: | 0.000 | 1: | 0.000 | | | | | | |
| | | 1: | 0.000 | | | | | | |
| 2: | -19042.253 | 1: | 0.000 | 2: | 4760.563 | | | | |
| | | 1: | 0.000 | 2: | 0.000 | | | | |
| 3: | 0.000 | 1: | 0.000 | 2: | 0.000 | 3: | 0.000 | | |
| | | 1: | 0.000 | 2: | 0.000 | 3: | 0.000 | | |
| 4: | 119.483 | 1: | 0.000 | 2: | -59.742 | 3: | 0.000 | 4: | 99.280 |
| | | 1: | 0.000 | 2: | 0.000 | 3: | 0.000 | 4: | 0.000 |
| 5: | 0.000 | 1: | 0.000 | 2: | 0.000 | 3: | 0.000 | 4: | 0.000 |
| | | 1: | 0.000 | 2: | 0.000 | 3: | 0.000 | 4: | 0.000 |
| 6: | -0.588 | 1: | 0.000 | 2: | 0.368 | 3: | 0.000 | 4: | -0.745 |
| | | 1: | 0.000 | 2: | 0.000 | 3: | 0.000 | 4: | 0.000 |
| 7: | 0.000 | 1: | 0.000 | 2: | -0.001 | 3: | 0.000 | 4: | 0.000 |
| | | 1: | 0.000 | 3: | 0.000 | 3: | 0.000 | 4: | 0.000 |
| 8: | 0.002 | 1: | 0.000 | 2: | -0.002 | 3: | 0.000 | 4: | 0.004 |
| | | 1: | 0.000 | 2: | 0.000 | 3: | 0.000 | 4: | 0.000 |

où la première colonne indique le degré n suivi de $Zx_n$ en ppm, suivi sur la même ligne des ordres m et $Xx_n^m$ la ligne immédiatement au-dessous donnant les m et $Yx_n^m$ en ppm.

On voit que pour les deux composantes, l'homogénéité est gouvernée par $Z_2$ ($Zx_2$) et qu'elle est moins bonne pour la composante $B_x$. Cependant 20000 ppm de $Zx_2$ avec $r_0$=10mm conduisent à seulement 0,5% d'homogénéité dans une sphère de référence de 10mm de diamètre, ce qui entre largement dans les spécifications. Par ailleurs, la composante $B_z$ ne comporte aucun terme non axial $X_{zn}^m$, $Y_{zn}^m$ pour m≤6 alors que la composante $B_x$ présente des termes $Xx_{2p}^{2q}$ significatifs.

On démontre que N doit être pair pour pouvoir annuler les termes $Xx_{2p+1}^{2q+1}$. Pour cette raison, N est généralement choisi pair.

Il convient de noter qu'une homogénéité satisfaisante a été obtenue alors même que le dimensionnement des bobines et des courants d'alimentation a été réalisé sans imposer aucune contrainte spécifique en ce sens.

Pour la deuxième configuration (N=4), on trouve pour la composante $B_z$:

| 0: | 1.091009 | | | | |
|---|---|---|---|---|---|
| 1: | 0.000 | 1: | 0.000 | | |
| | | 1: | 0.000 | | |
| 2: | 12437.599 | 1: | 0.000 | 2: | 0.000 |

(suite)

```
                        1:    0.000   2:    0.000

3:      0.000   1:   0.000   2:   0.000   3:   0.000
               1:   0.000   2:   0.000   3:   0.000

4:   -292.464   1:   0.000   2:   0.000   3:   0.000   4:   -72.985
               1:   0.000   2:   0.000   3:   0.000   4:    0.000

5:      0.000   1:   0.000   2:   0.000   3:   0.000   4:    0.000
               1:   0.000   2:   0.000   3:   0.000   4:    0.000

6:      2.824   1:   0.000   2:   0.000   3:   0.000   4:    2.079
               1:   0.000   2:   0.000   3:   0.000   4:    0.000

7:     -0.001   1:   0.000   2:   0.000   3:   0.000   4:    0.000
               1:   0.000   2:   0.000   3:   0.000   4:    0.000

8:     -0.019   1:   0.000   2:   0.000   3:   0.000   4:   -0.019
               1:   0.000   2:   0.000   3:   0.000   4:    0.000
```

et pour la composante $B_x$:

```
0:    1.091009
1:      0.000   1:   0.000
               1:   0.000

2:  -16297.492  1:   0.000        14070.148
               1:   0.000   2:      0.000

3:      0.000   1:   0.000   2:      0.000   3:   0.000
               1:   0.000   2:      0.000   3:   0.000

4:     53.007   1:   0.000        -91.394   3:   0.000   4:   49.605
               1:   0.000   2:      0.000   3:   0.000   4:    0.000

5:      0.000   1:   0.000   2:      0.000   3:   0.000        0.000
               1:   0.000   2:      0.000   3:   0.000   4:    0.000

6:      0.583   1:   0.000   2:     -0.726   3:   0.000   4:    0.122
               1:   0.000   2:      0.000   3:   0.000   4:    0.000

7:      0.000   1:   0.000   2:      0.001   3:   0.000   4:   -0.001
               1:   0.000            0.000   3:   0.000   4:    0.000

8:     -0.015   1:   0.000   2:      0.023   3:   0.000   4:   -0.012
               1:   0.000   2:      0.000   3:   0.000   4:    0.000
```

On constate que l'homogénéité est sensiblement moins bonne que pour la configuration avec N =6, notamment à cause du terme $Xx_2^2$ qui n'est pas nul. Toutefois, un autre paramètre doit être pris en considération: la valeur maximale du champ magnétique à l'intérieur du bobinage (« peak field ») ; cela est particulièrement important dans le cas des bobinages supraconducteurs, car dans ce cas cette valeur maximale ne doit pas dépasser un seuil dépendant du matériau supraconducteur utilisé. On trouve à ce propos que pour N=6 cette valeur vaut 5,75 T, est obtenu lorsqu'on génère un champ parallèle à la direction z et est localisé sur le rayon intérieur le plus éloigné du centre de chaque bobine. Pour N=4, le champ magnétique maximal est moins intense et vaut seulement 3,75 T, ce qui peut conduire à choisir cette configuration dans certaines applications. Il est possible de montrer que, si on prend N>6, l'homogénéité augmente mais le champ magnétique maximal aussi (par exemple, il dépasse les 9T pour N=9). Il faut aussi considérer que la complexité du système d'alimentation des bobines dépend de N. Pour ces raisons, les configurations avec N=4 et N=6 sont généralement préférées. Une configuration avec N=6 privilégie une meilleure homogénéité, tandis qu'une configuration avec N=4 réduit la valeur maximale du champ magnétique et permet d'utiliser un système d'alimentation plus simple (8 générateurs de courant indépendants au lieu de 12).

Il est possible de relâcher les conditions d'homogénéité et de valeur maximale du champ magnétique afin de minimiser le volume des conducteurs, tout en respectant les contraintes d'encombrement données plus haut ($\rho_0$=60mm, $d_0$=6mm) et avec $B_0$=1T, $j_0$=300 A/mm². On trouve :

| N | $a_0$ | $a_1$ | $a_2$ | $b_1$ | $b_2$ | V | PF | %@$r_0$ = 10 mm |
|---|-------|--------|-------|-------|--------|-------|-------|-----------------|
| 4 | 146 | 65.529 | 86 | 20 | 88.696 | 5.356 | 5.124 | 3.7 |
| 6 | 114 | 27.094 | 54 | 15 | 80.884 | 5.419 | 7.322 | 2.5 |

où « %@$r_0$=10 mm » représente l'inhomogénéité dans une sphère de 10 mm de rayon centrée sur le point O. Les dimensions $a_i$, $b_i$ sont en mm, V est en dm³ et PF est la valeur maximale du champ magnétique, en Tesla. Ici et dans tous les exemples qui suivent, les cotes sans décimales correspondent à des valeurs fixées a priori, comme par exemple des contraintes géométriques, tandis que celles avec décimales résultent d'une optimisation.

Le dimensionnement du dispositif est ainsi réduit à la résolution d'un problème d'optimisation non linéaire avec variables bornées (traduction des impératifs géométriques d'accessibilité) et contraintes non linéaires (champ magnétique produit et annulation de certains coefficients du développement en harmoniques sphériques pour assurer l'homogénéité). La fonction objectif à optimiser (minimiser) peut être le volume des bobinages - particulièrement dans le cas d'une réalisation en matériau supraconducteur - ou leur résistance - dans le cas d'une réalisation non supraconductrice.

Il convient de noter que, lorsque l'ouverture angulaire équatoriale est fixée, une augmentation de $a_2$ implique une augmentation de $b_1$, ce qui à son tour accroit le volume de conducteur requis.

On peut démontrer que, en coordonnées sphériques, le potentiel scalaire V*, dont le gradient multiplié par $-\mu_0$ donne le champ magnétique, et $B_x$ sont donnés par les équations suivantes :

$$V^* = \frac{1}{\mu_0} \sum_{n=3}^{\infty} r^n \left[ Z_n P_n(\cos\vartheta) + \sum_{m=1}^{n} \left( X_n^m \cos m\varphi + Y_n^m \sin m\varphi \right) P_n^m(\cos\vartheta) \right]$$

$$B_x = Zx_0 + \sum_{n=1}^{\infty} r^n \left[ Zx_n P_n(\cos\vartheta) + \sum_{m=1}^{n} \left( Xx_n^m \cos m\varphi + Yx_n^m \sin m\varphi \right) P_n^m(\cos\vartheta) \right]$$

où :

$$Xx_n^1 = Z_{n+1} - \frac{(n+2)(n+3)}{2} X_{n+1}^2 \quad \forall n \geq 1$$

$$Xx_n^m = \frac{1}{2} X_{n+1}^{m-1} - \frac{(n+m+1)(n+m+2)}{2} X_{n+1}^{m+1} \quad \forall n \geq 2, 2 \leq m \leq n$$

$$Yx_n^1 = -\frac{(n+2)(n+3)}{2} Y_{n+1}^2 \quad \forall n \geq 1$$

$$Yx_n^m = \frac{1}{2}Y_{n+1}^{m-1} - \frac{(n+m+1)(n+m+2)}{2}Y_{n+1}^{m+1} \quad \forall n \geq 2, \, 2 \leq m \leq n$$

$$Zx_n = -\frac{(n+1)(n+2)}{2}X_{n+1}^1 \quad \forall n \geq 0$$

En se limitant aux termes de plus bas degré qui interviennent dans la modélisation du système générant la composante $B_{xy}$, on trouve :

$$Zx_0 = -\frac{\mu_0 j_0}{a_0}\left\{\int_{a_1}^{a_2}\left[\frac{a_0^2 + a^2 + b^2}{r_1}K(k) - r_1 E(k)\right]da\right\}_{b_1}^{b_2} \; ;$$

$$Zx_2 = -\frac{\mu_0 j_0}{2a_0} \times$$

$$\left\{\int_{a_1}^{a_2}\left[\frac{\left[(a_0^2 - a^2)^2 + (a_0^2 + a^2)b^2\right]K(k)}{r_2^2} + \frac{(a_0^2 - a^2)^2(a_0^2 + a^2) + 2\left[(a_0^2 - a^2)^2 - 4a_0^2 a^2\right]b^2 + (a_0^2 + a^2)b^4}{r_2^2}E(k)\right]\frac{da}{r_1^3 r_2^2}\right\}_{b_1}^{b_2}$$

et

$$Xx_2^2 = -\frac{\mu_0 j_0}{12 a_0^3} \times$$

$$\left\{\int_{a_1}^{a_2}\left[\frac{\left[(a_0^2 - a^2)^2(a_0^2 + 4a^2) + (7a_0^4 + 3a_0^2 a^2 + 12a^4)b^2 + 2(5a_0^2 + 6a^2)b^4 + 4b^6\right]K(k)}{}\right.\right.$$
$$\left.\left. - \frac{\left[(a_0^2 - a^2)^2(a_0^4 - 7a_0^2 a^2 + 4a^4) + 8(a_0^6 - 2a_0^2 a^4 + 2a^6)b^2 + (17a_0^4 + 13a_0^2 a^2 + 24a^4)b^4 + 2(7a_0^2 + 8a^2)b^6 + 4b^8\right]}{r_2^2}E(k)\right]\frac{da}{r_1^3 r_2^2}\right\}_{b_1}^{b_2}$$

où :

$$k = \frac{2\sqrt{a_0 a}}{r_1}$$

$$r_1 = \sqrt{(a_0 + a)^2 + b^2}$$

$$r_2 = \sqrt{(a_0 - a)^2 + b^2}$$

et où K(k) et E(k) sont les intégrales elliptiques de Legendre complètes, respectivement de première et de deuxième espèce

En utilisant ces formules, on peut choisir les valeurs de $a$, $a_2$, $b_1$ et $b_2$ qui annulent les termes de plus bas degré qui ne sont pas nécessairement nul pour des raisons de symétrie, c'est-à-dire $Zx_2$ et $Xx_2{}^2$. On montre que pour N=4 il n'est pas possible de les annuler simultanément, tandis que pour N=6 le terme $Xx_2{}^2$ est nul pour des raisons de symétrie et il suffit de choisir les paramètres géométriques annulant $Zx_2$. On obtient ainsi des inhomogénéités de l'ordre de quelques ppm, au prix d'une augmentation significative (de l'ordre d'un facteur deux) du volume du conducteur.

Lorsqu'un dispositif selon le premier mode de réalisation de l'invention est utilisé pour générer autour du point O un champ magnétique présentant une composante $B_z$ non nulle, on obtient également un champ magnétique externe (« champ de fuite ») d'autant plus important que l'amplitude de $B_z$ - et donc du moment magnétique dipolaire - est élevée.

Si un tel champ de fuite est considéré comme gênant, il peut être réduit soit par un blindage actif au moyen de bobines supplémentaires, soit par un blindage passif en fer doux. Dans le cas présent, un blindage actif conduirait à une complexité et un encombrement difficilement acceptables. Un blindage passif peut être obtenu en insérant le système dans deux demi-cylindres circulaires d'axe Oz en fer doux séparés par l'entrefer nécessaire pour assurer l'ouverture équatoriale requise et fermés par deux fonds, le fond supérieur étant muni d'une ouverture circulaire pour assurer l'accessibilité axiale. L'inconvénient principal d'un tel blindage réside dans l'impossibilité d'en faire une modélisation précise, ce qui d'une part implique un étalonnage expérimental des courants à fournir aux bobines pour obtenir un champ d'intensité et de direction données, et d'autre part complique considérablement l'obtention de l'homogénéité souhaitée.

Le principal inconvénient du premier mode de réalisation de l'invention, qui vient d'être décrit, est constitué par la complexité de son système d'alimentation SA, qui comprend 2N (donc, en pratique, 8 ou 12) générateurs de courant pilotés indépendamment. Le deuxième mode de réalisation de l'invention permet d'obtenir une simplification considérable dudit système d'alimentation. Conformément à ce deuxième mode de réalisation, chaque élément $EB_n$ comprend (au moins) quatre bobines coaxiales : les bobines $B_n{}^1$ et $B_n{}^2$, précitées, qui sont utilisées uniquement pour générer la composante radiale du champ magnétique, et des bobines $B_n{}^3$ et $B_n{}^4$ - également agencées de manière symétrique de part et d'autre du plan xy, qui sont utilisées uniquement pour générer la composante axiale du champ magnétique. L'équation (5) montre que les bobines $B_n{}^3$ et $B_n{}^4$ sont toutes parcourues par un même courant $I_0 \cos\vartheta_0$ (qu'on appellera la composante $I_z$), tandis que le courant parcourant les bobines $B_n{}^1$ et $B_n{}^2$ vaut $(-1)^{i-1}\cdot I_0\cdot\sin\vartheta_0\cdot\cos(\varphi_n-\varphi_0)$ (qu'on appellera la composante $I_{xy}$). On remarque que les bobines $B_n{}^1$ et $B_n{}^2$ d'un même ensemble peuvent être connectées en série-opposition, et que deux ensembles agencés symétriquement par rapport au point O (ou à l'axe z) peuvent être connectés en série. Le nombre de générateurs nécessaires est donc de (N/2+1): N/2 générateurs pour les bobines $B_n{}^1$ et $B_n{}^2$, groupées quatre par quatre, et un seul générateur pour toutes les bobines $B_n{}^3$ et $B_n{}^4$. Concrètement, on passe de huit à trois générateurs pour N=4 et de douze à quatre pour N=6.

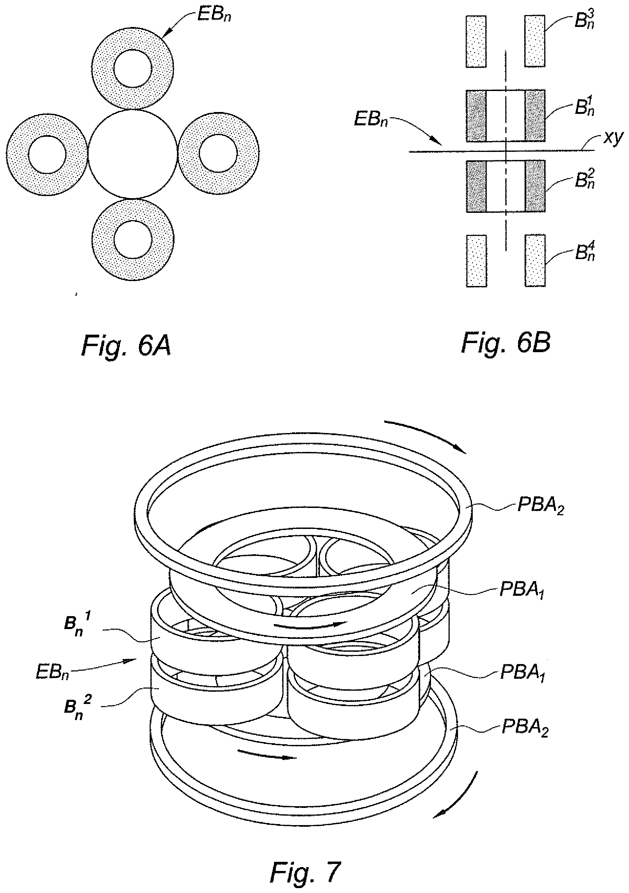

Les bobines $B_n{}^3$ et $B_n{}^4$ peuvent être enroulées à l'intérieur des bobines $B_n{}^1$ et $B_n{}^2$ correspondantes (figures 5A/5B) ou plus éloignées du plan xy que ces dernières (figures 6A/6B). Les figures représentent des configurations à 4 éléments, mais le deuxième mode de réalisation s'applique également à des configurations à 6 éléments ou plus.

La simplification du système d'alimentation obtenue grâce au deuxième mode de réalisation a des contreparties, à savoir une augmentation importante du volume du conducteur et un accroissement de la valeur maximale du champ magnétique.

La solution qui minimise le volume du conducteur est la suivante :

| N | $a_0$ | $a_1$ | $a_3$ | $a_2$ | $b_1$ | $b_2$ | V |
|---|-------|-------|--------|-------|-------|--------|--------|
| 4 | 173 | 71.160 | 94.113 | 113 | 20 | 79.531 | 11.528 |

où $a_3$ est le rayon de séparation des bobines internes et externes (autrement dit, les premières et deuxièmes bobines, générant le champ radial, s'étendent de $a_0$ à $a_3$ tandis que les troisièmes et quatrièmes bobines, générant le champ axial ou longitudinal s'étendent de $a_3$ à $a_2$). Les dimensions $a_i$, $b_i$ sont en mm, V est en $dm^3$. Dans la configuration de courant la plus défavorable, la valeur maximale du champ magnétique atteint 5,45 T pour un champ de 1T au point O.

Comme dans le cas du premier mode de réalisation on peut prévoir un blindage actif (très complexe) ou passif (nécessitant un étalonnage des valeurs de courant).

Le troisième mode de réalisation de l'invention permet de réaliser de façon simple un blindage actif, tout en maintenant le nombre de générateurs de courant égal à N/2+1. Ce troisième mode de réalisation ressemble au deuxième en ce que les premières et deuxièmes bobines, $B_n^1$ et $B_n^2$, sont utilisées seulement pour générer un champ magnétique radial, ce qui permet de grouper par quatre leurs alimentations. Toutefois, le champ magnétique axial n'est pas généré par des troisièmes et quatrièmes bobines $B_n^3$ et $B_n^4$, mais par deux paires de bobines dites « axiales » $PBA_1$ et $PBA_2$ présentant un axe commun orienté la direction z et passant par le point O, les bobines étant agencées symétriquement de part et d'autre dudit plan xy. L'utilisation de deux paires de bobines permet à la fois de générer un champ magnétique axial d'amplitude voulue à l'intérieur du dispositif, d'annuler le terme $Z_2$ de son DHS pour améliorer son homogénéité et d'annuler le moment dipolaire pour réduire le champ de fuite. Ce résultat peut être obtenu en alimentant les bobines axiales avec des courants circulant en sens inverse dans chaque paire et symétriques par rapport au plan xy. Ainsi, un seul générateur de courant est nécessaire pour les bobines axiales, ce qui conduit à un nombre total de générateurs égal à N/2+1, comme dans le cas du deuxième mode de réalisation.

Les figures 7, 8 et 9A/9B montrent trois dispositifs selon ce troisième mode de réalisation de l'invention.

Le dispositif de la figure 7 présente des bobines $B_n^1$ et $B_n^2$ dont les paramètres géométriques sont proches de ceux de l'exemple des figures 5A/5B :

| N | $a_0$ | $a_1$ | $a_2$ | $b_1$ | $b_2$ | V | PF | %@$r_0$ = 10 mm |
|---|-------|-------|-------|-------|-------|---|----|----------------|
| 4 | 180 | 105 | 120 | 20 | 88.882 | 5.843 | 3.368 | 3.25 |

Les dimensions $a_i$, $b_i$ sont en mm, V est en $dm^3$. Dans la configuration de courant la plus défavorable, la valeur maximale du champ magnétique atteint 3,368 T pour un champ de 1T au point O.

Pour les quatre bobines axiales on trouve :

| $a_1$ | $a_2$ | $b_1$ | $b_2$ | sgn(/) |
|-------|-------|-------|-------|--------|
| 271.507 | 300 | 230.424 | 250 | - |
| 168.989 | 246.420 | 100 | 113.489 | + |
| 168.989 | 246.420 | -113.489 | -100 | + |
| 271.507 | 300 | -250 | -230.424 | - |

$$V = 4.729 \; dm^3$$

où $a_1$ et $a_2$ sont définis par analogie avec les bobines $B_n^1$ et $B_n^2$.

Le champ de fuite à 0,5m du point O vaut 0,0376T pour la composante $B_z$ et 0,0109 T pour la composante $B_{xy}$. L'intensité du champ de fuite serait 10 à 20 fois plus élevée en l'absence du « blindage actif » réalisé par les bobines axiales.

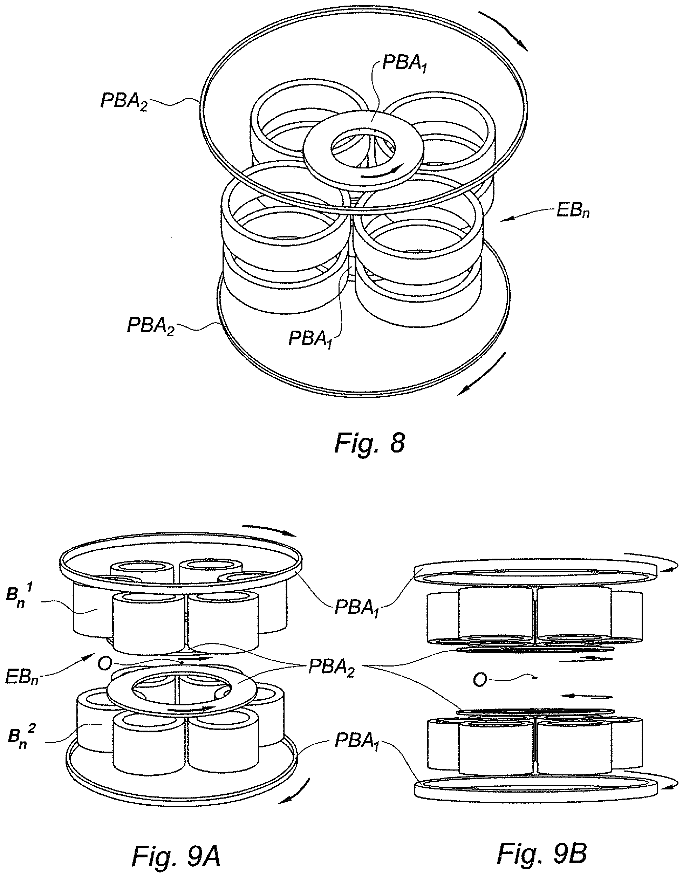

L'homogénéité de la composante axiale $B_z$ est de -9,286 ppm dans la sphère de rayon $r_0$=10 mm, c'est-à-dire bien meilleurs que celle de la composante radiale ; le signe « - » indique que le champ diminue lorsqu'on s'éloigne du centre de la sphère suivant l'axe z. On peut donc relâcher la condition d'annulation de $Z_2$ pour minimiser le volume des bobines axiales. On obtient ainsi le dispositif de la figure 8 :

| $a_1$ | $a_2$ | $b_1$ | $b_2$ | sgn(I) |
|-------|-------|-------|-------|--------|
| 295.024 | 300 | 231.577 | 250 | - |
| 60 | 115.390 | 100 | 118.435 | + |
| 60 | 115.390 | -118.435 | -100 | + |
| 295.024 | 300 | -250 | -231.577 | - |

$$V = 1.468 \; dm^3$$

Le gain en volume de conducteur est très important, alors que l'homogénéité devient 1,63 %@ $r_0$=10 mm (toujours meilleure que celle de la composante $B_{xy}$) et la valeur maximale du champ magnétique vaut 4,553T. Le champ de fuite à 0,5 m est réduit à 0,0022 T.

On peut a contrario rechercher une configuration qui améliore l'homogénéité de la composante $B_{xy}$ pour l'amener à un niveau comparable à celui de la composante $B_z$, en choisissant N=6 dimensionnant les bobines $B_n^1$ et $B_n^2$ de façon à annuler la composante $Zx_2$ du DHS de $B_{xy}$. Cette optimisation conduit au dispositif des figures 9A et 9B, dans lequel les bobines $B_n^1$ et $B_n^2$ sont caractérisées par les valeurs suivantes :

| N | $a_0$ | $a_1$ | $a_2$ | $b_1$ | $b_2$ | V |
|---|-------|-------|-------|-------|-------|---|
| 6 | 150 | 48.848 | 73 | 77.796 | 177.219 | 11.030 |

pour $B_0$=1T, $j_0$=300 A/mm² et un espacement minimum de 4mm entre deux bobines adjacentes. Le rayon extérieur hors tout est de $a_0+a_2$=223 mm, ce qui permet de limiter le rayon hors tout des bobines axiales de compensation active de la composante $B_z$ à 250 mm. Par ailleurs, $b_1$ prend une valeur beaucoup plus important de celle garantissant l'ouverture angulaire équatoriale requise ; par conséquent on peut implanter la paire de bobines axiales $PBA_1$ entre les premières et deuxièmes bobines.

L'inhomogénéité de la composante radiale du champ magnétique dans une sphère de 10 mm de rayon est inférieure à 3,93 ppm ; la valeur maximale du champ magnétique est de 6,521T et le champ de fuite à 0,5 m est de 0,0342T.

Le dimensionnement des bobines axiales donne :

| $a_1$ | $a_2$ | $b_1$ | $b_2$ | sgn($I$) |
|-------|-------|-------|-------|----------|
| 241.662 | 250 | 205.607 | 225 | - |
| 106.124 | 161.102 | 60 | 69.819 | + |
| 106.124 | 161.102 | -69.819 | -60 | + |
| 241.662 | 250 | -225 | -205.607 | - |

$$V = 1.406 \; dm^3$$

L'homogénéité est de -2,904 ppm @$r_0$=5mm et -46,239 ppm @$r_0$=10 mm ; la valeur maximale du champ magnétique vaut 2,622 T, le champ de fuite à 0,5m vaut 0,0101T.

Cette configuration est remarquablement flexible et peut être facilement adaptée à des contraintes variées car les codes d'optimisation pour chacune des deux types de composantes du champ sont extrêmement rapides (50 ms environ pour chacune des configurations).

Si l'on se contente de générer un champ magnétique orientable dans le plan xy, les paires de bobines axiales peuvent être omises, et si la présence d'un champ de fuite ne pose pas de problème, une seule paire de bobines axiales peut être suffisante. Il est également envisageable de combiner le deuxième et troisième mode de réalisation, ajoutant une ou deux paires de bobines axiales à un dispositif selon le deuxième mode de réalisation de l'invention.

La composante $I_{xy}$ du courant alimentant les premières et deuxièmes bobines est proportionnelle à $\cos(\varphi_n-\varphi_0)$, où $\varphi_0$ est l'angle azimutal du champ magnétique généré. On comprend que, si on prend $\varphi_0$ variable linéairement dans le temps ($\varphi_0=\omega t$) on obtiendra un champ magnétique tournant sur un cône de demi-angle au somme égal à $\vartheta_0$, ce qui a des applications notamment en résonance magnétique nucléaire. Dans ce cas, la composante $I_{xy}$ varie sinusoïdalement dans le temps, avec une fréquence angulaire $\omega$. Plus généralement, le courant d'alimentation des bobines peut varier d'une façon plus complexe de manière à générer un champ magnétique de direction et/ou d'amplitude variables.

## Revendications

1. Dispositif de génération d'un champ magnétique orientable et localement homogène, comportant N≥3 ensembles ($EB_n$) identiques de bobines cylindriques, chaque dit ensemble comportant au moins une première ($B_n^1$) et une deuxième ($B_n^2$) bobine, lesdites bobines étant coaxiales avec un axe orienté le long d'une direction z et étant agencées symétriquement de part et d'autre d'un plan xy perpendiculaire audit axe z, avec un espacement dans la direction axiale ; lesdites premières bobines étant toutes agencées du même côté dudit plan xy et lesdites deuxièmes bobines étant toutes agencées de l'autre côté dudit plan xy ; lesdits ensembles étant agencés de telle sorte que leurs traces dans ledit plan xy soient régulièrement espacées le long d'un cercle de centre O et de rayon $a_0$>0, en laissant un espace libre central (ELC), le dispositif comportant également un système d'alimentation (SA) configuré pour alimenter chaque dite bobine avec un courant $I_n^i$, n étant un indice représentatif de l'ensemble de bobines et i étant égal à 1 pour lesdites premières bobines et à 2 pour lesdites deuxièmes bobines, exprimé par la somme d'un premier terme $I_z$, ayant une même valeur pour toutes les bobines, et d'un deuxième terme $I_{xy}$ égal à $(-1)^{l-1} \cdot I_0 \cdot \sin\vartheta_0 \cdot \cos(\varphi_n - \varphi_0)$, où $I_0$ est une intensité nominale de courant, $\varphi_n$ est l'angle azimutal, par rapport à une direction de référence dans le plan xy, du n-ème ensemble de bobines, $\varphi_0$ est l'angle azimutal, par rapport à cette même direction de référence, d'un champ magnétique à générer au centre dudit cercle par lesdites bobines et $\vartheta_0$ est l'angle zénithal de ce même champ magnétique par rapport à l'axe z, au moins l'angle $\varphi_0$ étant réglable par un utilisateur.

2.  Dispositif selon la revendication 1, dans lequel le nombre N d'ensembles de bobines est pair.

3.  Dispositif selon la revendication 2, dans lequel le nombre N d'ensembles de bobines est choisi parmi 4 et 6.

4.  Dispositif selon l'une des revendications précédentes, dans lequel lesdites premières et deuxièmes bobines sont identiques, sauf tout au plus pour leur sens d'enroulement.

5.  Dispositif selon l'une des revendications précédentes, dans lequel N est un nombre pair supérieur ou égal à 6 et dans lequel le diamètre interne $a_1$, le diamètre externe $a_2$, la distance $b_1$ du plan xy et la hauteur $b_2 - b_1$ desdites bobines sont choisis de sorte à annuler au moins les termes d'ordre 2 de développements en harmoniques sphériques à l'intérieur d'une sphère imaginaire située au centre dudit espace libre.

6.  Dispositif selon l'une des revendications précédentes, dans lequel ledit système d'alimentation est configuré de telle sorte que la composante $I_z$ du courant d'alimentation desdites premières et deuxièmes bobines vaille $-I_0 \cos\vartheta_0$, et dans lequel le diamètre interne $a_1$, la distance $b_1$ du plan xy et la hauteur $b_2$ desdites bobines sont choisis de telle sorte que la composante radiale $B_{\rho n}$ du champ magnétique généré par le n-ème ensemble de bobine soit égale au double de la composante axiale $B_{zn}$ de ce champ en correspondance dudit centre O.

7.  Dispositif selon l'une des revendications 1 à 5, dans lequel chaque dit ensemble comporte également une troisième $(B_n{}^3)$ et une quatrième $(B_n{}^4)$ bobine cylindrique, coaxiales avec les dites première et deuxième bobine et étant agencées symétriquement de part et d'autre dudit plan, avec un espacement dans la direction axiale ; et dans lequel ledit système d'alimentation est configuré de telle sorte que la composante $I_z$ du courant d'alimentation desdites premières et deuxièmes bobines soit nulle; et que le courant d'alimentation desdites troisièmes et quatrièmes bobines de tous les ensembles vaille $I_{3,4} = -I_0 \cos\vartheta_0$.

8.  Dispositif selon la revendication 7, dans lequel lesdites troisièmes et quatrièmes bobines sont enroulées à l'intérieur des premières et deuxièmes bobines des ensembles correspondants.

9.  Dispositif selon la revendication 7, dans lequel lesdites troisièmes et quatrièmes bobines sont plus éloignées du plan xy que les premières et deuxièmes bobines des ensembles correspondants.

10. Dispositif selon l'une des revendications 1 à 6, comportant également une première (PBA1) et une deuxième (PBA2) paire de bobines cylindriques coaxiales, présentant un axe commun orienté selon ladite direction z et passant par le centre dudit cercle, les bobines étant agencées symétriquement de part et d'autre dudit plan xy; ledit système d'alimentation est configuré de telle sorte que la composante $I_z$ du courant d'alimentation desdites premières et deuxièmes bobines soit nulle ; et que les deux dites paires de bobines soient parcourues par des courants en sens inverse dans chaque paire et de valeurs permettant à la fois d'annuler le moment magnétique dipolaire à l'extérieur du dispositif et faire en sorte que le champ magnétique généré par l'ensemble des bobines du dispositif au centre dudit cercle soit orienté selon un angle zénithal $\vartheta_0$.

11. Dispositif selon la revendication 10 dans lequel les diamètres, les hauteurs et les positionnements axiaux des bobines des deux dites paires sont choisis de sorte à annuler également au moins les termes d'ordre 1 et 2 du développement en harmoniques sphériques de la composante orientée selon ladite direction z dudit champ magnétique à l'intérieur d'une sphère imaginaire située au centre dudit espace libre.

12. Dispositif selon l'une des revendications 10 et 11, dans lequel une dite paire de bobines est agencée dans l'espacement entre lesdites premières et deuxièmes bobines, et l'autre paire est agencée extérieurement auxdites premières et deuxièmes bobines dans ladite direction z.

13. Dispositif selon l'une des revendications 7 à 12 dans lequel N est un nombre pair et les premières et deuxièmes bobines des ensembles agencés symétriquement par rapport au centre dudit cercle sont connectées en série entre elles et à un générateur de courant commun.

14. Dispositif selon l'une des revendications précédentes dans lequel lesdites bobines présentent des densités moyennes d'enroulement uniformes.

15. Dispositif selon l'une des revendications précédentes, dans lequel ledit système d'alimentation est configuré pour alimenter lesdites premières et deuxièmes bobines avec un courant variable sinusoïdalement dans le temps, moyennant quoi un champ magnétique tournant est généré dans ledit espace libre central.

**Patentansprüche**

1. Vorrichtung zur Erzeugung eines orientierbaren und örtlich homogenen Magnetfelds, die $N \geq 3$ identische Gruppen ($EB_n$) von zylindrischen Spulen umfasst, wobei jede Gruppe mindestens eine erste ($B_n^1$) und eine zweite ($B_n^2$) Spule umfasst, wobei die Spulen mit einer Achse koaxial sind, die entlang einer Richtung z orientiert ist, und symmetrisch auf beiden Seiten einer Ebene xy, die senkrecht zur Achse z ist, mit einem Abstand in der axialen Richtung angeordnet sind;
   wobei die ersten Spulen alle auf derselben Seite der Ebene xy angeordnet sind und die zweiten Spulen alle auf der anderen Seite der Ebene xy angeordnet sind;
   wobei die Gruppen derart angeordnet sind, dass ihre Spuren in der Ebene xy gleichmäßig entlang eines Kreises mit dem Mittelpunkt 0 und dem Radius $a_0 > 0$ beabstandet sind, indem ein mittlerer freier Raum (ELC) gelassen wird, wobei die Vorrichtung auch ein Versorgungssystem (SA) umfasst, das ausgestaltet ist, um jede der Spulen mit einem Strom $I_n^i$ zu versorgen, wobei n ein Index ist, der die Gruppe von Spulen darstellt, und i für die ersten Spulen gleich 1 und für die zweiten Spulen gleich 2 ist, durch die Summe eines ersten Terms $I_z$, der für alle Spulen den gleichen Wert aufweist, und eines zweiten Terms $I_{xy}$, der gleich $(-1)^{i-1} \cdot I_0 \cdot sin\,\vartheta_0 \cdot cos(\varphi_n - \varphi_0)$ ist, ausgedrückt ist, wo $I_0$ eine Nennstromstärke ist, $\varphi_n$ der Azimutwinkel in Bezug zu einer Bezugsrichtung in der Ebene xy der n-ten Gruppe von Spulen ist, $\varphi_0$ der Azimutwinkel in Bezug zu dieser gleichen Bezugsrichtung eines in der Mitte des Kreises durch die Spulen zu erzeugenden Magnetfelds ist und $\vartheta_0$ der Zenitwinkel dieses gleichen Magnetfelds in Bezug zu der Achse z ist, wobei mindestens der Winkel $\varphi_0$ durch einen Benutzer einstellbar ist.

2. Vorrichtung nach Anspruch 1, wobei die Anzahl N von Spulengruppen gerade ist.

3. Vorrichtung nach Anspruch 2, wobei die Anzahl N von Spulengruppen zwischen 4 und 6 gewählt ist.

4. Vorrichtung nach einem der vorhergehenden Ansprüche, wobei die ersten und die zweiten Spulen bis auf allenfalls ihre Wicklungsrichtung identisch sind.

5. Vorrichtung nach einem der vorhergehenden Ansprüche, wobei N eine gerade Zahl größer oder gleich 6 ist und wobei der Innendurchmesser $a_1$, der Außendurchmesser $a_2$, der Abstand $b_1$ von der Ebene xy und die Höhe $b_2 - b_1$ der Spulen derart ausgewählt sind, dass mindestens die Terme der Ordnung 2 von Entwicklungen in Kugelfunktionen im Inneren einer gedachten Kugel, die sich in der Mitte des freien Raumes befindet, aufgehoben werden.

6. Vorrichtung nach einem der vorhergehenden Ansprüche, wobei das Versorgungssystem derart ausgestaltet ist, dass die Komponente $I_z$ des Stroms zur Versorgung der ersten und zweiten Spulen $-I_0 cos\,\vartheta_0$ beträgt und wobei der Innendurchmesser $a_1$, der Abstand $b_1$ von der Ebene xy und die Höhe $b_2$ der Spulen derart gewählt sind, dass die radiale Komponente $B_{pn}$ des Magnetfelds, das durch die n-te Spulengruppe erzeugt wird, gleich dem Doppelten der axialen Komponente $B_{zn}$ dieses Feldes im Bereich des Mittelpunkts 0 ist.

7. Vorrichtung nach einem der Ansprüche 1 bis 5, wobei jede Gruppe auch eine dritte ($B_n^3$) und eine vierte ($B_n^4$) zylindrische Spule umfasst, die koaxial zu der ersten und zweiten Spule sind und symmetrisch auf beiden Seiten der Ebene mit einem Abstand in der axialen Richtung angeordnet sind; und wobei das Versorgungssystem derart ausgestaltet ist, dass die Komponente $I_z$ des Stroms zur Versorgung der ersten und zweiten Spulen null ist; und dadurch, dass der Strom zur Versorgung der dritten und vierten Spulen von allen Gruppen $I_{3,4} = -I_0 cos\,\vartheta_0$ beträgt.

8. Vorrichtung nach Anspruch 7, wobei die dritten und vierten Spulen im Inneren der ersten und zweiten Spulen der entsprechenden Gruppen gewickelt sind.

9. Vorrichtung nach Anspruch 7, wobei die dritten und vierten Spulen weiter von der Ebene xy entfernt sind als die ersten und zweiten Spulen der entsprechenden Gruppen.

10. Vorrichtung nach einem der Ansprüche 1 bis 6, die auch ein erstes (PBA1) und ein zweites (PBA2) Paar koaxialer zylindrischer Spulen umfasst, die eine gemeinsame Achse aufweisen, die entlang der Richtung z orientiert ist und durch den Mittelpunkt des Kreises verläuft, wobei die Spulen symmetrisch auf beiden Seiten der Ebene xy angeordnet sind; wobei das Versorgungssystem derart ausgestaltet ist, dass die Komponente $I_z$ des Stromes zur Versorgung der ersten und zweiten Spulen null ist; und dass die zwei Paare von Spulen durch Ströme in umgekehrter Richtung in jedem Paar und mit Werten durchflossen werden, die es ermöglichen, sowohl den magnetischen Dipolmoment außerhalb der Vorrichtung aufzuheben, als auch zu bewirken, dass das durch die Spulengruppe der Vorrichtung in der Mitte des Kreises erzeugte Magnetfeld entlang eines Zenitwinkels $\vartheta_0$ orientiert ist.

11. Vorrichtung nach Anspruch 10, wobei die Durchmesser, die Höhen und die axialen Positionierungen der Spulen der zwei Paare derart ausgewählt sind, dass die Terme der Ordnung 1 und 2 der Entwicklung in Kugelfunktionen der entlang der Richtung z orientierten Komponente des Magnetfelds im Inneren einer gedachten Kugel, die sich in der Mitte des freien Raumes befindet, aufgehoben wird.

12. Vorrichtung nach einem der Ansprüche 10 und 11, wobei ein Paar von Spulen in dem Raum zwischen den ersten und zweiten Spulen angeordnet ist und das andere Paar außerhalb der ersten und zweiten Spulen in der Richtung Z angeordnet ist.

13. Vorrichtung nach einem der Ansprüche 7 bis 12, wobei N eine gerade Zahl ist und die ersten und zweiten Spulen der Gruppen, die symmetrisch zur Mitte des Kreises angeordnet sind, untereinander in Reihe und mit einem gemeinsamen Stromgenerator verbunden sind.

14. Vorrichtung nach einem der vorhergehenden Ansprüche, wobei die Spulen gleichförmige mittlere Wicklungsdichten aufweisen.

15. Vorrichtung nach einem der vorhergehenden Ansprüche, wobei das Versorgungssystem ausgestaltet ist, um die ersten und zweiten Spulen mit einem zeitlich variablen Sinusstrom zu versorgen, wodurch ein drehendes Magnetfeld in dem mittleren freien Raum erzeugt wird.

**Claims**

1. Device for generating an orientable and locally uniform magnetic field, comprising N≥3 identical assemblies ($EB_n$) of cylindrical coils, each of said assemblies comprising at least a first ($B_n^1$) and a second ($B_n^2$) coil, said coils being coaxial with an axis oriented along a direction z and being arranged symmetrically on either side of a plane xy perpendicular to said z-axis, with a gap in the axial direction, said first coils being arranged on the same side of said xy-plane and said second coils being arranged on the other side of said xy-plane; said assemblies being arranged such that their outlines in said xy-plane are regularly spaced along a circle of centre O and of radius $a_0>0$, so as to leave a central free space (ELC), the device also comprising a supply system (SA) configured to supply each of said coils with a current $I_n^i$, n being an index representing the coil assembly and i being equal to 1 for said first coils and to 2 for said second coils, expressed by the sum of a first term $I_z$ having a same value for all the coils, and a second term $I_{xy}$ equal to $(-1)^{i-1} \cdot I_0 \cdot \sin\vartheta_0 \cdot \cos(\varphi_n - \varphi_0)$, where $I_0$ is a nominal current, $\varphi_n$ is the azimuthal angle, relative to a reference direction in the xy-plane, of the nth coil assembly, $\varphi_0$ is the azimuthal angle, relative to the same reference direction, of a magnetic field to be generated in the centre of said circle by said coils, and $\vartheta_0$ s the zenith angle of the same magnetic field relative to the z-axis, at least the angle $\varphi_0$ being adjustable by a user.

2. Device according to Claim 1, in which the number N of coil assemblies is even.

3. Device according to Claim 2, in which the number N of coil assemblies is chosen from 4 and 6.

4. Device according to any one of the preceding claims, in which said first and second coils are identical, except, at the very most, for their winding direction.

5. Device according to any one of the preceding claims, in which N is an even number higher than or equal to 6 and in which the inside diameter $a_1$, the outside diameter $a_2$, the distance $b_1$ from the xy-plane, and the height $b_2-b_1$ of said coils are chosen so as to cancel out at least the 2nd order terms of the expansion in spherical harmonics inside an imaginary sphere located at the centre of said free space.

6. Device according to any one of the preceding claims, in which said supply system is configured such that the component $I_z$ of the current supplying said first and second coils is $-I_0\cos\vartheta_0$, and in which the inside diameter $a_1$, the distance $b_1$ from the xy-plane and the height $b_2$ of said coils are chosen such that the radial component $B_{\rho n}$ of the magnetic field generated by the $n^{th}$ coil assembly is equal to twice the axial component $B_{zn}$ of this field at said centre O.

7. Device according to any one of claims 1 to 5, in which each of said assemblies also comprises a third ($B_n^3$) and a fourth ($B_n^4$) cylindrical coil coaxial with said first and second coils, and being arranged symmetrically on either side of said plane with a gap in the axial direction; and in which said supply system is configured such that the component $I_z$ of the current supplying said first and second coils is zero; and the current supplying said third and fourth coils of all the assemblies is $I_{3,4}=-I_0\cos\vartheta_0$.

8. Device according to Claim 7, in which said third and fourth coils are wound inside the first and second coils of the corresponding assemblies.

9. Device according to Claim 7, in which said third and fourth coils are further removed from the xy-plane than the first and second coils of the corresponding assemblies.

10. Device according to any one of claims 1 to 6, also comprising a first (PBA1) and a second (PBA2) pair of coaxial cylindrical coils having a common axis oriented in said z-direction and passing through the centre of said circle, the coils being arranged symmetrically on either side of said xy-plane; said supply system is configured such that the component $I_z$ of the supply current of said first and second coils is zero; and currents flow through said two pairs of coils in opposite directions in each pair, the currents having values allowing both the dipolar magnetic moment outside of the device to be cancelled out, and the magnetic field generated by all the coils of the device at the centre of said circle to be oriented at a zenith angle $\vartheta_0$.

11. Device according to Claim 10, in which the diameters, heights and axial positions of the coils of said two pairs are chosen so as also to cancel out at least the 1 st and 2nd order terms of the expansion in spherical harmonics of the component oriented in said z-direction of said magnetic field inside an imaginary sphere located at the centre of said free space.

12. Device according to any one of Claims 10 and 11, in which one of said pairs of coils is arranged in the gap between said first and second coils, and the other pair is arranged externally to said first and second coils in said z-direction.

13. Device according to any one of Claims 7 to 12, in which N is an even number and the first and second coils of the assemblies arranged symmetrically relative to the centre of said circle are connected in series with one another and to a common current generator.

14. Device according to any one of the preceding Claims , in which said coils have uniform average winding densities.

15. Device according to any one of the preceding Claims, in which said supply system is configured to supply said first and second coils with a current varying sinusoidally over time, by way of which a rotating magnetic field is generated in said central free space.

*Fig. 1*

*Fig. 2*

*Fig. 3A*

*Fig. 3B*

*Fig. 4A*

*Fig. 4B*

*Fig. 5A*

*Fig. 5B*

*Fig. 6A*

*Fig. 6B*

*Fig. 7*

Fig. 8

Fig. 9A

Fig. 9B

**EP 2 743 717 B1**

## RÉFÉRENCES CITÉES DANS LA DESCRIPTION

**Documents brevets cités dans la description**

- US 20080024130 A
- WO 2005029110 A
- WO 2007048983 A